# EUROPÄISCHE PATENTSCHRIFT

(11) **EP 3 132 180 B1**
(45) Veröffentlichungstag und Bekanntmachung des Hinweises auf die Patenterteilung: **29.08.2018**
(21) Anmeldenummer: 15710765.7
(22) Anmeldetag: 17.03.2015
(51) Int. Cl.: F21K 9/00, F21K 9/64, H01L 25/075, F21Y 105/12, F21Y 105/18, F21Y 113/13, F21Y 115/10

(54) **LED-MODUL ZUR ABGABE VON WEISSLICHT**
LED MODULE FOR EMITTING WHITE LIGHT
MODULE À DEL SERVANT À ÉMETTRE UNE LUMIÈRE BLANCHE

(30) Priorität: 27.03.2014 DE 202014101449 U; 02.07.2014 DE 202014103033 U
(43) Veröffentlichungstag der Anmeldung: 22.02.2017
(73) Patentinhaber: Tridonic Jennersdorf GmbH, 8380 Jennersdorf (AT)
(72) Erfinder: WIMMER, Florian, 2650 Payerbach (AT); GUMHOLD, Jürgen, 8380 Jennersdorf (AT)
(74) Vertreter: Rupp, Christian
(86) Internationale Anmeldenummer: PCT/EP2015/055526
(87) Internationale Veröffentlichungsnummer: WO 2015/144492

(56) Entgegenhaltungen:
- JP-A- 2013 118 198
- JP-A- 2013 118 198
- US-A1- 2012 224 364
- US-A1- 2012 224 364
- US-A1- 2013 264 947

## Beschreibung

### 1. Gebiet der Erfindung

Die vorliegende Erfindung betrifft ein LED-Modul (Leuchtdioden-Modul) zur Abgabe von Mischlicht, vorzugsweise von Weißlicht. Insbesondere betrifft die vorliegende Erfindung ein LED-Modul, das für Leuchten mit kleinen Reflektorgrößen geeignet ist. Die vorliegende Erfindung betrifft schließlich ebenfalls eine Leuchtvorrichtung mit einem solchem LED-Modul.

### 2. Hintergrund

Die Druckschrift US 2013/264947 A1 offenbart ein Remote-Phosphor-LED-Gerät mit einem Breitbandausgang und einer steuerbaren Farbe, die Druckschrift US 2012/224364 A1 offenbart ein LED-Beleuchtungsgerät und die Druckschrift JP 2013 118198 A offenbart eine Beleuchtungsvorrichtung.

Aus dem Stand der Technik sind LED-Module bekannt, die zur Abgabe von Weißlicht geeignet sind. Diese LED-Module weisen in der Regel ein lichtabstrahlendes Lichtfeld auf, das durch eine Kombination einzelner Lichtpunkte gebildet wird. Die einzelnen Lichtpunkte sind dazu ausgelegt, unterschiedliche Lichtspektren abzugeben. Beispielsweise wird von den Lichtpunkten blaues Licht, rotes Licht und von einem Leuchtstoff erzeugtes gelbes Licht abgegeben.

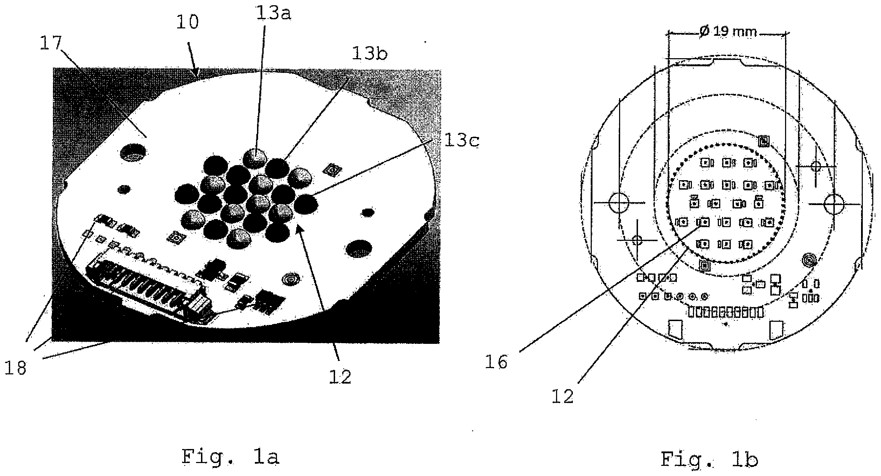

Ein solches bekanntes LED-Modul 10 ist beispielsweise in der Figur 1a gezeigt. Figur 1b zeigt eine Draufsicht desselben LED-Moduls 10. Das LED-Modul 10 besitzt ein Lichtfeld 12, das zusammen mit weiteren Komponenten 18 auf einer Modulplatte 17 angeordnet ist. Das Lichtfeld12 ist aus mehreren Lichtpunkten 13a, 13b, 13c gebildet, die jeweils Licht aus einem anderen Wellenlängenbereich, d.h. ein anderes Lichtspektrum, abgeben. Jedem der Lichtpunkte 13a, 13b, 13c ist, wie in Figur 1b gezeigt, wenigstens eine LED 16 zugeordnet. Die Lichtpunkte 13a, 13b, 13c sind in der Regel durch sogenannte Globe-Tops (Dispenstropfen) über den LEDs 16 gebildet.

Das bekannte LED-Modul 10 hat den Nachteil, dass es ein zu großes Lichtfeld 12 aufweist, um damit Leuchten mit kleinen Reflektorgrößen auszustatten. Ein in Figur 1b gezeigtes Lichtfeld 12 weist dabei in der Praxis einen Durchmesser von mindestens 19mm auf, wobei es mit der Globe-Top Methode (durch Dispensverfahren) grundsätzlich nicht möglich ist den Durchmesser des Lichtfelds 12 weiter zu verringern.

Im Lichte dieses Standes der Technik ist es eine der Aufgaben der vorliegenden Erfindung, ein LED-Modul zur Abgabe von Mischlicht, vorzugsweise ein (Misch-)Weißlicht, bereitzustellen, das den bekannten Stand der Technik verbessert. Insbesondere soll ein LED-Modul bereitgestellt werden, mit dem ein besonders homogenes Mischlicht erzeugt werden kann. Weiterhin ist es eine Aufgabe der vorliegenden Erfindung, ein LED-Modul bereitzustellen, das für Leuchten mit kleinen Reflektorgrößen geeignet ist.

Diese und andere Aufgaben, die beim Lesen der folgenden Beschreibung noch genannt werden oder vom Fachmann erkannt werden können, werden durch den Gegenstand der unabhängigen Ansprüche gelöst. Die abhängigen Ansprüche bilden den zentralen Gedanken der vorliegenden Erfindung in besonders vorteilhafter Weise weiter.

### 3. Ausführliche Beschreibung der Erfindung

Gemäß der vorliegenden Erfindung wird ein LED-Modul zur Abgabe von Mischlicht bereitgestellt, umfassend: ein Lichtfeld, das in mehrere flächige Sektoren zum Abgeben von unterschiedlichen Lichtspektren unterteilt ist, wobei die flächigen Sektoren des Lichtfeldes als Kreissektoren und Kreisringsektoren ausgebildet sind und wobei das Lichtfeld mit den flächigen Sektoren durch Dispensverfahren hergestellt ist.

Als flächiger Sektor im Sinne der vorliegenden Erfindung ist dabei allgemein eine zusammengehörige Fläche zu verstehen, die bevorzugt durch Dämme/Trennwände von den weiteren (benachbarten) flächigen Sektoren getrennten ist.

Als Lichtfeld wird eine Lichtabstrahlfläche des erfindungsgemäßen LED-Moduls bezeichnet. Durch die flächige Sektorenaufteilung des Lichtfeldes ist es möglich, die Gesamtfläche des Lichtfeldes im Vergleich mit der Gesamtfläche eines bekannten LED-Moduls, das durch Globe-Tops definierte Lichtpunkte enthält, deutlich zu reduzieren. Durch die Sektorenanordnung kann die Gesamtlichtabstrahlfläche des Lichtfeldes insbesondere um mindestens ca. 16% verkleinert werden. Eine solche Verringerung ist mit dem aus dem Stand der Technik bekannten Globe-Top Ansatz grundsätzlich nicht möglich. Durch die deutliche Flächenverringerung des Lichtfeldes ist das erfindungsgemäße LED-Modul auch für Leuchten mit kleinen Reflektorgrößen (beispielsweise als sogenanntes Spotmodul) geeignet.

Vorteilhafterweise sind für jedes Lichtspektrum wenigstens zwei flächige Sektoren vorgesehen.

Das erfindungsgemäße LED-Modul ist vorzugsweise dazu ausgelegt, zwei unterschiedliche Lichtspektren abzugeben. Jeweils ein Lichtspektrum wird dabei vorzugsweise aus wenigstens zwei der flächigen Sektoren des Lichtfeldes ausgekoppelt. Dadurch kann insgesamt ein sehr homogenes und farbtreues Mischlicht, insbesondere ein Weißlicht (mit hohem CRI), von dem LED-Modul erzeugt werden.

Vorzugsweise ist das Lichtspektrum jedes Sektors weiss, unterscheidet sich aber durch die Farbtemperatur. Dazu können bspw. in jedem Sektor die gleichen (bspw. blauen) LED Chips vorliegen, aber unterschiedliche Farbkonversionsstoffe und/oder unterschiedliche Konzentrationen an Farbkonversionsstoffen verwendet werden.

Vorteilhafterweise ist die Außenkontur des Lichtfeldes kreisförmig. Die Kreisform ist insbesondere für Leuchten von Vorteil, die Optiken mit aufgesetztem Reflektor aufweisen.

Sowohl die Kreissektoren als auch die Kreisringsektoren sind dabei als flächige Sektoren anzusehen. Durch diese vorteilhafte Anordnung der flächigen Sektoren in dem Lichtfeld, kann beispielweise ein LED-Modul gebildet werden, das Mischlicht aus zumindest zwei verschiedenen Lichtspektren abgibt und dabei eine besonders kleine Gesamtlichtabstrahlfläche aufweist. Das Lichtfeld kann also flächenreduziert werden. Darüber hinaus kann durch die vorgeschlagene Ausbildung der Lichtfläche ein besonders homogenes Mischlicht erzeugt werden, da sich die jeweilige Lichtabstrahlung in besonders vorteilhafter Weise *"Durchmischen".*

Die flächigen Sektoren können dabei zum Abgeben von rotem, blauem Licht und von Licht aus einem weiteren Lichtspektrum ausgelegt, welches vorzugsweise durch einen Leuchtstoff erzeugt wird. Dieses weitere Lichtspektrum kann beispielweise Licht aus dem grünen und/oder gelben Lichtspektrum sein.

Die Flächigen Sektoren können beispielsweise Weißlicht mit unterschiedlichen Farbtemperaturen z.B. so-genannte Kalt- und/oder Warmweiße Spektren abgeben.

Die unterschiedlichen Lichtspektren werden dabei besonders bevorzugt derart bereitgestellt, dass auf, vorzugsweise baugleiche, LED-Chips/LED-Stränge, die bevorzugt ein blaues Lichtspektrum bereitstellen, eine Vergussmasse mit unterschiedlichen Leuchtstoffkonzentrationen und/oder Leuchtstoffen bzw. Leuchtstoffkombinationen aufgebracht wird (d.h. es liegt vorzugsweise kein sogenannter Remote-Phosphor vor, sondern die Vergussmassen werden unmittelbar auf die LED-Chips aufgebracht). Die Vergussmasse ist dabei vorzugsweise eine Vergussmasse auf Silikon und/oder Epoxybasis.

Die Vergussmasse kann zusätzlich Streupartikel aufweisen.

Vorteilhafterweise weist das Lichtfeld einen Durchmesser von 16 mm oder weniger auf. Durch diesen im Vergleich zum Stand der Technik deutlich reduzierten Lichtfelddurchmesser ist das erfindungsgemäße LED-Modul dazu geeignet, eine Leuchte mit kleinen Reflektorgrößen umzusetzen.

Vorteilhafterweise weist das LED-Modul ferner eine Lichtstreuscheibe auf, die in einem Abstand zum Lichtfeld in Lichtabstrahlrichtung des Lichtfeldes angeordnet ist.

Die Lichtstreuscheibe verleiht dem LED-Modul einen noch homogeneren Farbeindruck, d.h. durch die Streuung des Lichts wird die Vermischung der unterschiedlichen Lichtspektren, die von dem Lichtfeld abgegeben werden, nochmals verbessert. Die Lichtstreuscheibe ermöglicht es ferner, ein diffuses Licht zu erzeugen und die Helligkeit des LED-Moduls einzustellen. Die Lichtstreuscheibe kann zusätzlich mit einem Leuchtstoff versehen sein, beispielweise mit einer zusätzlichen Leuchtstoffschicht oder eingebetteten Leuchtstoffpartikeln. Die Streuscheibe ist dann dazu geeignet die Farbe oder Farbtemperatur des von dem LED-Modul insgesamt abgegebenen Lichts zu beeinflussen.

Vorteilhafterweise ist die Streuscheibe durch eine Mischkammer von der Oberseite des Lichtfeldes getrennt. Die Mischkammer sorgt vorzugsweise für eine besonders effektive Vermischung der unterschiedlichen Lichtspektren, die von den flächigen Sektoren des Lichtfeldes ausgestrahlt werden. Für einen Betrachter des LED-Moduls ist dann ein sehr homogenes Mischlicht sichtbar. Die einzelnen flächigen Sektoren des Lichtfeldes bzw. die davon ausgesandten unterschiedlichen Lichtspektren sind vorzugsweise von außen für einen Betrachter nicht zu erkennen.

Das Lichtfeld mit den flächigen Sektoren ist durch Dispensverfahren hergestellt, bei dem die Vergussmasse mit dem Farbkonversionsstoff dispenst wird, nachdem ein vorgefertigter oder vor Ort ausgehärteter Damm aufgebracht wurde. Durch diese auch als *"dam-and-fill"* Verfahren bezeichnete Methode können besonders einfach die flächigen Sektoren des Lichtfeldes hergestellt werden. Die Methode ermöglicht ein deutlich kleineres Lichtfeld, als es mit der bekannten Methode, in welcher die Globe-Tops direkt auf den einzelnen LED Chips aufgebracht sind, zu erreichen. Die flächigen Sektoren können ein

Fertigbauteil sein, das auf einer Modulplatte des LED-Moduls angebracht wird.

Vorteilhafterweise sind die flächigen Sektoren des Lichtfeldes durch Dämme bzw. Trennwände voneinander getrennt. Die Dämme können dabei entweder unmittelbar auf dem Trägermaterial durch Aufgetragen und Ausgehärtet eines geeigneten Materials gebildet werden (durch ein so-genannte Dispensverfahren) oder zunächst als separates Bauteil hergestellt werden, das anschließend mit dem Trägermaterial verbunden wird. Die Dämme weisen dabei bevorzugt eine in Draufsicht gesehene Breite zwischen 50 µm und 2 mm auf, besonders bevorzugt zwischen 100 µm und 1 mm und weiter bevorzugt zwischen 300 µm und 800 µm.

Vorteilhafterweise umfassen die flächigen Sektoren des Lichtfeldes eine transparente Vergussmasse oder eine einen Leuchtstoff enthaltende Vergussmasse (beispielsweise eine Phosphorbeladung, wobei die jeweiligen flächigen Sektoren mit unterschiedlichen Phosphorbeladungen ausgebildet sein können, so dass unterschiedliche Lichtspektren bereitgestellt werden können).

Bevorzugt sind in dem erfindungsgemäßen LED-Modul die einzelnen Sektoren des Lichtfeldes durch die begrenzenden Dämme definiert und in die Zwischenräume zwischen den Dämmen ist eine Vergussmasse eingefüllt, um die Sektoren flächig zu gestalten. Wie ausgeführt, kann die Vergussmasse aus einer transparenten Vergussmasse mit zugesetztem Leuchtstoff bestehen, der beispielweise als darin dispergierte Leuchtstoffpartikel vorliegt. Die Vergussmasse kann auch gelöste Leuchtstoffe enthalten, d.h. sie kann eine Leuchtstoff-Vergussmasse sein.

Ein Leuchtstoff (auch Farbkonversionsstoff genannt) ist allgemein ein Stoff, der durch Licht anregbar ist und daraufhin ein sekundäres Lichtspektrum abgibt (beispielsweise Phosphor). Ein Leuchtstoff kann deshalb ein Lichtfarbkonversionsstoff sein. Beispielweise ist der Leuchtstoffein anorganisches Material oder ein Q-dot (z.B. ZnS, ZnSe, CdS, CdSe, ZnTe, CdTe). Bevorzugt wird durch den Leuchtstoff sekundäres Licht aus dem gelben, grünen und/oder rotem Spektrumbereich abgegeben.

Anwendbare Leuchtstoffe sind aus dem Stand der Technik bekannt z.B. Silikate (Ca₃Sc₂Si₃O₁₂: Ce3+), Ortho-silikate (BOSE), Granate (YAG: Ce³⁺, (YGd)AG: Ce³⁺, LuAG: Ce³⁺), Oxides (CaScO₂: Eu²⁺), SiALONs (α-SiALON: Eu²⁺, β-SiALON: Eu²⁺), Nitride (La₃Si₆N₁₁: Ce³⁺, CaAlSiN₃:Ce³⁺), Oxy-nitride (SrSi₂N₂O₂: Eu²⁺, (Ca,Sr,Ba)Si₂N₂O₂: Eu²⁺).

Die vorliegende Erfindung versteht unter Licht aus dem roten Lichtspektrum Licht mit einer Peakwellenlänge zwischen etwa 580 und 670 nm, unter Licht aus dem blauen Lichtspektrum Licht mit einer Peakwellenlänge zwischen etwa 390 bis 480 nm, unter Licht aus dem grünen Lichtspektrum Licht mit einer Peakwellenlänge zwischen etwa 480 und 560 nm und unter Licht aus dem gelben Lichtspektrum Licht mit einer Peakwellenlänge zwischen 560 und 630 nm.

Das erfindungsgemäße LED-Modul ist dadurch zum Abgeben von Weißlicht, insbesondere von natürlich wirkendem Weißlicht, geeignet. Natürlich wirkendes Weißlicht hat bevorzugt eine Lichtfarbtemperatur, die der eines schwarzen Strahlers entspricht.

Vorteilhafterweise sind die flächigen Sektoren jeweils mit wenigstens einer LED oder mit zumindest einem LED-Strang versehen. Weiterhin ist es bevorzugt, dass jeder Kreissektor bzw. jeder Kreisringsektor die gleiche Anzahl an (beispielsweise blauen) LEDs aufweist (beispielsweise können in den Kreissektoren bzw. in den Kreisringsektoren baugleiche LED-Stränge verwendet werden). Die LED-Stränge sind dabei vorzugsweise separat oder in miteinander verschalteten Gruppen (je nach Anzahl der eingesetzten LED-Stränge) ansteuerbar. Dabei können beispielsweise die LED-Stränge, die zur Abgabe eines ersten Lichtspektrums vorgesehen sind und die LED-Stränge, die zur Abgabe eines zweiten Lichtspektrums vorgesehen sind, jeweils in Gruppen miteinander verschaltet werden. Dadurch kann ein beliebiges Mischlicht im Bereich zwischen dem ersten und dem zweiten Lichtspektrum eingestellt und abgegeben werden.

Die wenigstens eine LED oder der wenigstens eine LED-Strang (d.h. mehrere verschaltete LEDs), sitzt bevorzugt zwischen den Dämmen der einzelnen Sektoren auf einer Modulplatte (bzw. Trägerplatte) des LED-Moduls. Vorzugsweise sind die LED oder der LED-Strang mit der Vergussmasse vergossen. Dadurch werden die LEDs oder der LED-Strang fixiert und geschützt. Das von der LED oder dem LED-Strang abgegebene Licht wird von der Vergussmasse aus dem LED-Modul transportiert und dabei gegebenenfalls durch einen Leuchtstoff in der Vergussmasse beeinflusst oder konvertiert. Die LEDs können zum Beispiel blauleuchtende, rotleuchtende, grünleuchtende, gelbleuchtende (amber)oder im UV leuchtende LEDs sein. Das von einem flächigen Sektor abgegebene Lichtspektrum kann durch ein Zusammenspiel zwischen wenigstens einer LED und der Vergussmasse zustande kommen, oder direkt von der wenigstens einen LED erzeugt werden. Die flächigen Sektoren können rotes, grünes, gelbes, grün-gelbes oder weißes Licht mit unterschiedlichen Weißtönen emittieren. Diese Lichtfarben können durch die eingesetzten monochromatischen LEDs und/oder durch die eingesetzten Leuchstoffe(n) erzeugt werden.

Die vorliegende Erfindung betrifft ferner ein LED-Modul hergestellt mit einem Verfahren, das die Schritte aufweist: Erzeugen eines Lichtfeldes, das in flächige Sektoren unterteilt ist, wobei die flächigen Sektoren des Lichtfeldes als Kreissektoren und Kreisringsektoren ausgebildet sind, durch Ausbilden von Dämmen, welche Sektoren des Lichtfeldes voneinander trennen, und Einfüllen einer transparenten Vergussmasse oder einer einen Leuchtstoff enthaltenden Vergussmasse zwischen die Dämme eines jeden Sektors.

Die vorliegende Erfindung betrifft ferner eine Leuchtvorrichtung, die wenigstens ein LED-Modul wie oben beschrieben und vorzugsweise einen auf das LED-Modul gesetzten Reflektor aufweist.

### 4. Beschreibung von bevorzugten Ausführungsformen

Die vorliegende Erfindung wird nun noch detaillierter mit Bezug auf die beigefügten Zeichnungen beschrieben.
Figuren 1a und 1b zeigen ein LED-Modul, das aus dem Stand der Technik bekannt ist.
Die Figuren 2a und 2b zeigen ein LED-Modul mit einer ersten Ausführungsform eines Lichtfelds.
Die Figur 3 zeigt eine zweite Ausführungsform eines Lichtfelds für ein LED-Modul.
Die Figur 4 zeigt eine dritte Ausführungsform eines Lichtfelds für ein LED-Modul.
Die Figur 5 zeigt eine vierte Ausführungsform eines Lichtfelds für ein LED-Modul gemäß der vorliegenden Erfindung.
Die Figur 6 zeigt eine fünfte Ausführungsform eines Lichtfelds für ein LED-Modul gemäß der vorliegenden Erfindung.
Die Figur 7 zeigt eine bevorzugte Anordnung und Verschaltung der LED-Stränge des in Figur 6 gezeigten Lichtfelds.

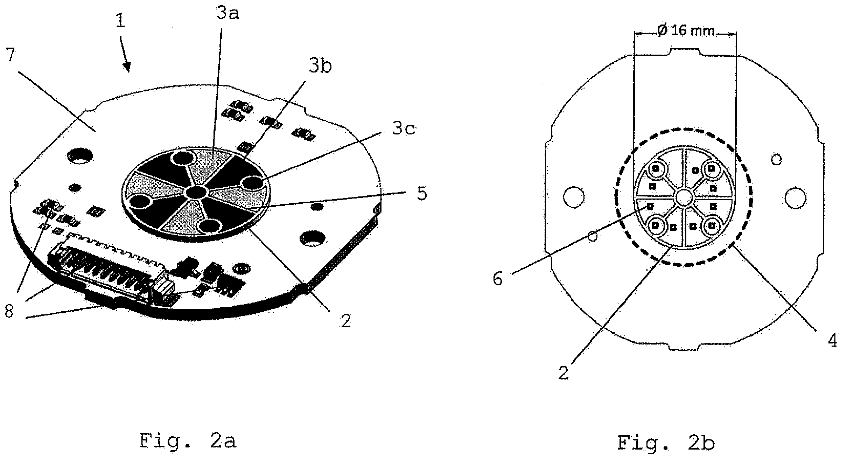

Die Figur2a zeigt eine dreidimensionale seitliche Ansicht eines LED-Moduls 1 mit einer ersten Ausführungsform eines Lichtfelds 2. Das LED-Modul 1 ist zur Abgabe von Mischlicht, beispielsweise zur Abgabe von Weißlicht, geeignet. Dazu werden in dem LED-Modul 1 verschiedene abgegebene Lichtspektren derart gemischt, dass als Gesamteindruck für einen Betrachter das Mischlicht oder das Weißlicht des LED-Moduls 1 entsteht.

Das LED-Modul 1 weist eine Modulplatte 7 auf, auf der wenigstens ein Lichtfeld 2 angeordnet ist, das zur Abgabe des Lichts des LED-Moduls 1 ausgelegt ist. Das Lichtfeld 2 strahlt das Licht aus seiner flächigen Oberfläche ab. Ferner sind vorteilhafter Weise auf der Modulplatte 7 noch weitere Komponenten 8 angeordnet. Diese weiteren Komponenten 8 können beispielweise elektronische Komponenten sein wie Ansteuerungskomponenten, Mikroprozessoren, Kapazitäten, Induktivitäten, Widerstände, elektrische Zuleitungen oder dergleichen. Die elektronischen Komponenten können LEDs 6 oder LED-Stränge des LED-Moduls 1 mit Energie versorgen und/oder steuern. Die weiteren Komponenten 8 können auch Kühlelemente zum Abführen von Wärme von der Modulplatte 7 bzw. dem Lichtfeld 2 enthalten. Ferner kann die Modulplatte 7 mit Anbringungsmitteln zum Anbringen des LED-Moduls 1 in beispielweise einem Leuchtengehäuse versehen sein. Beispielsweise weist die Modulplatte 7 wie in Figur 1a gezeigt Löcher zum Anschrauben des LED-Moduls 1 auf. Die Modulplatte 7 kann beispielsweise eine Leiterplatte wie ein Printed Circuit Board (PCB) sein. Die Modulplatte 7 ist vorteilhafter Weise wenigstens teilweise aus einem Material gebildet, das zur Wärmeabfuhr geeignet ist.

Das Lichtfeld 2 des LED-Moduls 1 ist in mehrere flächige Sektoren 3a, 3b, 3c (hier Kreissektoren und Kreisflächen) unterteilt. Jeder der Sektoren 3a, 3b, 3c ist zur Abgabe von Licht aus einem bestimmten Lichtspektrum ausgelegt. Das Lichtfeld 2 umfasst vorzugsweise wenigstens eine erste Art von Sektoren 3a (hier Kreissektoren), die Licht aus einem ersten Lichtspektrum abgeben, und eine zweite Art von Sektoren 3b (hier Kreissektoren), die Licht aus einem zweiten Lichtspektrum abgeben. Vorzugsweise umfasst das Lichtfeld 2 auch eine dritte Art von Sektoren 3c (hier Kreisflächen), die Licht aus einem dritten Lichtspektrum abgeben. Natürlich können auch mehr verschiedene Arten von Sektoren verwendet werden, die insgesamt vier oder sogar mehr verschiedene Lichtspektren abgeben.

Für jedes abgegebene Lichtspektrum umfasst das Lichtfeld 2 vorzugsweise wenigstens zwei Sektoren 3a, 3b, 3c. Um Weißlicht mit einer vorbestimmten Farbtemperatur und/oder Farbwiedergabe (CRI: Color Rendering Index) als das Mischlicht zu erzeugen, kann das Lichtfeld 2 beispielsweise eine erste Art von Sektoren 3a umfassen, die Weißlicht abgeben, das vorzugsweise von einem blauen LED und einem in der Vergussmasse eingebrachten Leuchtstoff erzeugt wird, eine zweite Art von Sektoren 3b umfassen, die blaues Licht (vorzugsweise emittiert von den monochromatischen blauen LEDs) abgeben, und eine dritte Art von Sektoren 3c umfassen, die Licht aus einem weiteren Lichtspektrum abgeben,. Dieses weitere Lichtspektrum umfasst vorteilhafterweise das blaue Lichtspektrum. Denkbar ist es, daß Sektoren 3b Weißlicht mit einer unterschiedlichen Farbtemperatur /Emisionsspektrum im Vergleich mit Sektoren 3a aufzeigen.

Dadurch, dass in dem erfindungsgemäßen LED-Modul 2 die verschiedenen Bereiche des Lichtfeldes 2, welche unterschiedliche Lichtspektren abgeben, nicht durch Lichtpunkte sondern durch flächige Sektoren 3a, 3b, 3c gebildet werden, ist eine Verringerung der Gesamtfläche des Lichtfeldes 2 möglich. Die Gesamtlichtabstrahlfläche des LED-Moduls 1 kann also reduziert werden.

Vorzugsweise ist, wie in Figuren2a und 2b gezeigt, das Lichtfeld 2 rund. Insbesondere besitzt das Lichtfeld 2 am meisten bevorzugt eine kreisförmige Außenkontur, kann aber auch oval, ellipsenförmig oder dergleichen sein. Der Durchmesser des Lichtfelds 2 beträgt vorzugsweise 16mm oder weniger. Die Fläche des Lichtfelds 2 kann etwa 200 mm² oder weniger betragen und ist im Vergleich zum Stand der Technik um 16% verringert. Das kreisförmige Lichtfeld 2 weist, wie in Figur2a gezeigt, vorzugsweise eine Unterteilung in verschiedene Arten von Kreissektoren 3a bzw. 3b auf.

Das in den Figuren 2a und 2b gezeigte Lichtfeld 2 weist ferner mehrerer kreisförmige Inseln 3c auf, die innerhalb der Außenkontur des Lichtfeldes 2 angeordnet sind. Beispielsweise kann, wie in der Figur2a gezeigt, eine kreisförmige Insel 3c die Mitte des Lichtfeldes 2 bilden, d.h. zum Beispiel den Mittelpunkt der kreisförmigen Außenkontur bilden.

Zusätzlich können weitere kreisförmige Inseln 3c beispielweise in regelmäßigen Abständen dem Umfang des Lichtfeldes 2 entlang angeordnet sein.

Vorzugsweise sind die kreisförmigen Inseln 3c zum Abgeben von Licht aus dem roten Spektrum vorgesehen. Die echten Kreissektoren 3a bzw. 3b sind vorzugsweise zum Abgeben von Licht aus dem blauen und/oder einem weiteren Lichtspektrum, das beispielsweise von einem Leuchtstoff erzeugt wird, vorgesehen. Durch eine Auswahl der Durchmesser der kreisförmigen Inseln 3c und/oder der Flächen der Kreissektoren 3a bzw. 3b während des Herstellungsprozesses des LED-Moduls 1, kann die Farbe des LED-Moduls 1 bzw. dessen Farbtemperatur festgelegt werden.

Die flächigen Sektoren 3a, 3b, 3c des Lichtfeldes 2 werden vorzugsweise durch Dämmen und Füllen gebildet. Dazu werden in einem ersten Schritt Dämme 5 auf der Modulplatte 7 des LED-Moduls ausgebildet, die die spätere Struktur der Sektoren 3a, 3b, 3c festlegen. Durch einen Damm 5 wird dabei die Außenkontur des Lichtfeldes 2 gebildet. Zur Unterteilung Sektoren 3a, 3b, 3c werden beispielweise geradlinige oder gebogene Dämme 5 innerhalb der Außenkontur des Lichtfeldes 2 gezogen. Zur Bildung von kreisförmigen Inseln können kreisförmige Dämme 5 innerhalb der Außenkontur des Lichtfeldes 2 gebildet werden.

Sobald die Dämme 5 auf der Modulplatte 7 ausgebildet sind, werden die dadurch festgelegten Zwischenräume gefüllt. Die Füllung erfolgt entweder mit einer transparenten Vergussmasse oder mit einer Vergussmasse, die mit einem Leuchtstoff, beispielsweise mit Leuchtstoffpartikeln, versehen ist. Leuchtstoffpartikel können in der Vergussmasse als pulverförmiger Leuchtstoff vorgesehen sein. Auch die Vergussmasse selbst kann lichtkonvertierende Eigenschaften aufweisen. Ein Leuchtstoff zeichnet sich generell dadurch aus, dass er von Licht einer LED 6 angeregt werden kann und daraufhin ein Sekundärlichtspektrum abgibt. Die Dämme 5 können dabei entweder unmittelbar auf der Modulplatte 7 (dem Trägermaterial) durch Aufgetragen und Ausgehärtet eines geeigneten Materials gebildet werden oder zunächst als separates Bauteil hergestellt werden, das anschließend mit der Modulplatte 7 verbunden wird. Die Dämme 5 weisen dabei bevorzugt eine in Draufsicht gesehene Breite zwischen 50 µm und 2 mm auf, besonders bevorzugt zwischen 100 µm und 1 mm und weiter bevorzugt zwischen 300 µm und 800 µm.

In jedem flächigen Sektor 3a, 3b, 3c wird vorzugsweise vor dem Schritt des Füllens wenigstens eine LED 6 bzw. ein LED-Strang angeordnet. Vorzugsweise werden in den als Kreissektoren ausgebildeten flächigen Sektoren 3a, 3b LED-Stränge mit identischer Anzahl an LEDs angeordnet. Die LEDs oder LED-Stränge können aber auch schon zuvor in die Modulplatte 7 eingelassen worden sein und die Sektoren 3a, 3b, 3c werden folglich über den LEDs 6 ausgebildet. Die Dämme 5 können auch um auf der Modulplatte 7 angeordnete LEDs 6 bzw. LED-Stränge herum ausgebildet werden. Die LEDs 6 bzw. LED-Stränge werden vorzugsweise von der Vergussmasse, die zwischen die Dämme 5 gefüllt wird, umschlossen. Die LEDs 6 oder LED-Stränge sind über die Modulplatte 7 mit Strom versorgt und vorzugsweise separat oder in Gruppen ansteuerbar.

Diejenigen Sektoren 3a, 3b, 3c, die mit einer transparenten Vergussmasse gefüllt sind, sind dazu ausgelegt, von einer oder mehreren LEDs 6 abgegebenes Licht unverändert abzugeben. Beispielsweise kann von solchen Sektoren 3a, 3b, 3c rotes und/oder blaues Licht von einer rotleuchtenden und/oder blauleuchtenden LED 6 abgegeben werden. Diejenigen Sektoren 3a, 3b, 3c, die mit einer einen Leuchtstoff enthaltenden Vergussmasse gefüllt sind, sind hingegen dazu ausgelegt, von einer oder mehreren LEDs 6 abgegebenes Licht verändert abzugeben. Dies geschieht beispielsweise dadurch, dass das Licht dieser LEDs 6 den Leuchtstoff in der Vergussmasse anregt, wodurch von diesem ein Sekundärlichtspektrum abgegeben wird. Beispielsweise kann dadurch gelbes, grünes oder rotes Licht erzeugt und abgegeben werden.

In dem Lichtfeld 2 des LED-Moduls 1 kann jeder flächige Sektor 3a, 3b, 3c mit einer Vergussmasse versehen sein, die das Licht der eingeschlossenen LED 6 verändern kann oder aber nur einige der Sektoren 3a, 3b, 3c. Es ist sogar möglich, dass jeder einzelne Sektor 3a, 3b, 3c des Lichtfeldes 2 selbst dazu ausgelegt ist, ein Weißlicht zu erzeugen. Beispielsweise kann dazu in jedem Sektor 3a, 3b, 3c eine blau leuchtende LED 6 eingesetzt sein, und kann für jeden Sektor eine andere Leuchtstoff-Vergussmasse als Füllung verwendet sein. Dadurch wird ein Weißlicht durch eine Kombination beispielsweise von drei verschiedenen Weißlichten erzeugt und es kann eine besonders natürliche Farbtemperatur beispielsweise mit einer hohen Farbwiedergabe (CRI) erreicht werden.

Die LEDs 6 bzw. LED-Stränge in den verschiedenen Sektoren 3a, 3b, 3c des Lichtfeldes 2 können einzeln oder gemeinsam derart ansteuerbar sein, dass ihre Leuchtfarbe durch die Ansteuerung veränderbar ist. Ferner kann vorzugsweise jede LED 6 oder LED-Strecke einzeln gedimmt werden, beispielsweise mittels Pulsbreiten-Modulation.

Figur 2b zeigt eine Draufsicht auf das LED-Modul 1. Wie gezeigt, kann vor der Lichtabstrahlfläche des Lichtfeldes 2 eine Streuscheibe 4 angeordnet sein, die hier als gestrichelter Kreis dargestellt ist. Die Streuscheibe 4 besitzt wenigstens denselben Durchmesser wie das Lichtfeld 2, vorzugsweise einen größeren Durchmesser. Die Streuscheibe 4 kann mit Streupartikeln versehen sein, die derart gewählt sind, dass sie das von dem Lichtfeld 2 abgegebene Licht streuen. Dazu weisen die Streupartikel eine Korngröße auf, die etwa der Wellenlänge der abgegebenen Lichtspektren entspricht. Vorzugsweise ist die Streuscheibe 4 von der Oberseite des Lichtfeldes2 beabstandet angeordnet.

Zwischen der Oberseite des Lichtfeldes 2 und der Streuscheibe 4 ist vorzugsweise eine sogenannte Mischkammer vorhanden. Im einfachsten Fall ist die Mischkammer lediglich ein Freiraum zwischen dem Lichtfeld 2 und der Streuscheine 4. Die Mischkammer ist aber vorzugsweise dazu ausgelegt, eine effektive Durchmischung der verschiedenen Lichtspektren, die vom Lichtfeld 2 abgegeben werden, zu erzielen. Dazu können in der Mischkammer zum Beispiel optische Elemente vorgesehen sein. Optische Elemente sind beispielsweise Linsen oder Reflektoren. Die Mischkammer kann aber auch ein solider Block aus einem Material sein, das einen hohen Brechungsindex, beispielweise von 1,5 oder mehr aufweist. Insgesamt wird durch die Mischkammer und die Streuscheibe 4 zusammen erreicht, dass die einzelnen Lichtspektren, die von den verschiedenen flächigen Sektoren 3a, 3b, 3c des Lichtfeldes 2 abgegeben werden, nicht mehr von einem Betrachter des LED-Moduls 1 unterscheidbar sind, sondern als homogenes Mischlicht, vorzugsweise homogenes Weißlicht, erscheinen.

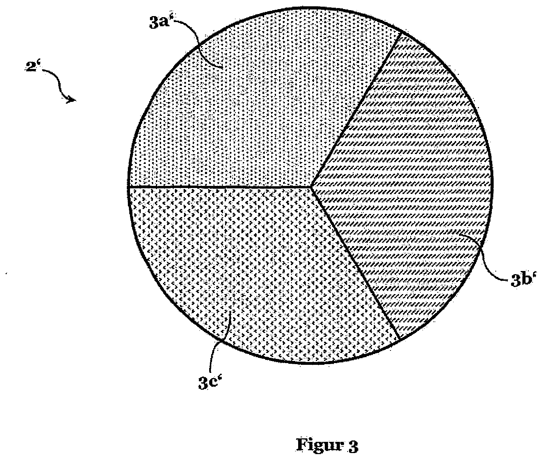

Die Figur 3 zeigt eine zweite Ausgestaltung eines Lichtfelds 2' für ein LED-Modul. Im Unterschied zum in den Figuren 2a und 2b gezeigten Lichtfeld 2, umfasst das Lichtfeld 2' keine kreisförmigen Inseln 3c, sondern jeweils nur einen Kreissektor 3a', 3b' und 3' zur Abgabe von Licht aus einem bestimmten Lichtspektrum. Das Lichtfeld 2' umfasst dabei einen ersten Sektor 3a, der Licht aus einem ersten Lichtspektrum, einen zweiten Sektor 3b, der Licht aus einem zweiten Lichtspektrum und einen dritten Sektor 3c, der Licht aus einem dritten Lichtspektrum abgeben kann.

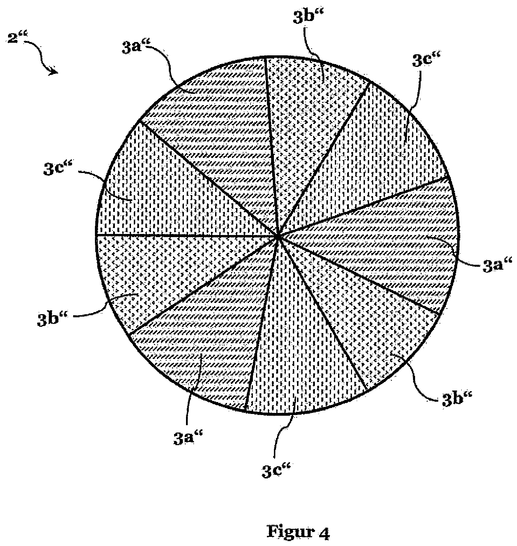

Die Figur 4 zeigt eine dritte Ausgestaltung eines Lichtfelds 2" für ein LED-Modul. Wiederum umfasst das Lichtfeld 2" keine kreisförmigen Inseln 3c, sondern jeweils verschiedene Sektoren 3a", 3b" und 3c". Dabei umfasst das Lichtfeld 2" eine erste Art von Sektoren 3a, die Licht aus einem ersten Lichtspektrum, eine zweite Art von Sektoren 3b, die Licht aus einem zweiten Lichtspektrum und eine dritte Art von Sektoren 3c, die Licht aus einem dritten Lichtspektrum abgeben können.

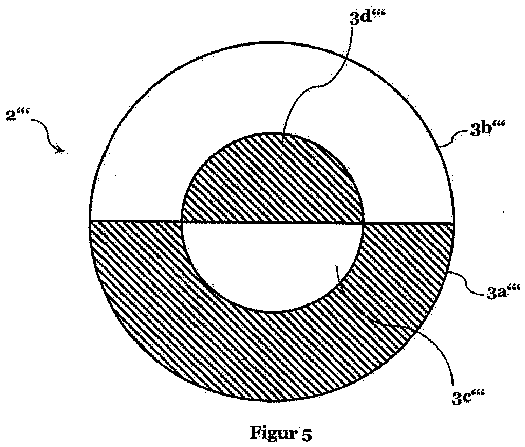

Die Figur 5 zeigt ein vierte Ausgestaltung eines Lichtfelds 2"' für ein LED-Modul 1 gemäß der vorliegenden Erfindung.

Im Unterschied zu den oben erläuterten Ausgestaltungen des Lichtfelds weist das Lichtfeld 2"' als flächige Sektoren Kreissektoren 3c"', 3d"' (in der gezeigten Ausführungsform Halbkreise) und Kreisringsektoren 3a"', 3b"' auf. Dabei sind ein Kreissektor 3d"' und ein Kreisringsektor 3a"' derart ausgebildet, um ein erstes Lichtspektrum abgeben zu können und ein Kreissektor 3c"' und Kreisringsektor 3b"', um ein zweites Lichtspektrum abgeben zu können. Die flächigen Segmente 3a"', 3d"" zur Abgabe des ersten Lichtspektrums sind dabei zur Verdeutlichung mit einer Schraffur versehen, die flächigen Segmente 3b"', 3c"' zur Abgabe des zweiten Lichtspektrums weisen keine Schraffur auf. Im Ergebnis kann durch die zwei Lichtspektren ein Mischlicht (vorzugsweise ein Weißlicht) erzeugt werden, wobei jeweils ein Lichtspektrum durch zwei flächige Sektoren erzeugt wird.

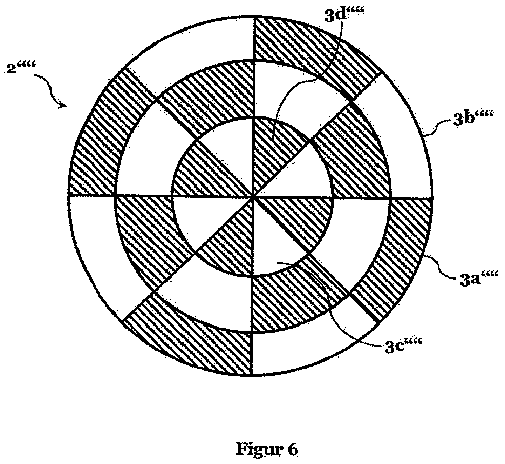

Die Figur 6 zeigt eine fünfte bevorzugte Ausführungsform eines Lichtfelds 2"" für ein LED-Modul 1 gemäß der vorliegenden Erfindung, das sich besonders bevorzugt zur Abgabe eines sehr homogenen (Weiß-)Lichts eignet. Wie in Figur 6 gezeigt, weist das Lichtfelds 2"" im Vergleich zum Lichtfeld 2"' eine höhere Anzahl von Kreissektoren 3c"", 3d"" und Kreisringsektoren 3a"", 3b"" auf, wobei das Grundprinzip jedoch dasselbe ist.

Durch das Lichtfeld 2"" kann ein Mischlicht aus einem ersten Lichtspektrum (bereitgestellt durch die mit einer Schraffur versehenen Kreissektoren 3d"" und Kreisringsektoren 3a"") und einem zweiten Lichtspektrum (bereitgestellt durch die Kreissektoren 3c"" und Kreisringsektoren 3b"" ohne Schraffur) bereitgestellt werden. Wie in Figur 6 zu erkennen, sind die flächigen Sektoren vergleichbar angeordnet, wie die Flächen einer Dartscheibe. Durch die vorgeschlagene Unterteilung der flächigen Sektoren kann daher eine besonders hohe *"Durchmischung"* des jeweils abgestrahlten Lichts bereitgestellt werden, und damit ein besonders homogenes Mischlicht/Weißlicht.

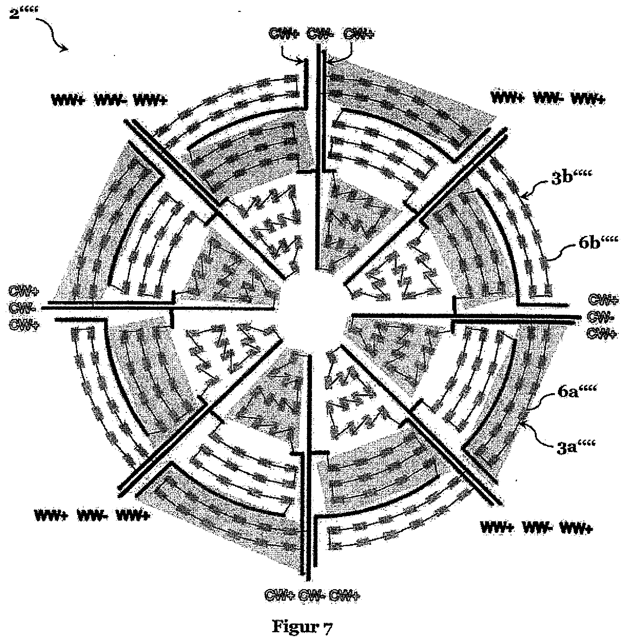

Die Figur 7 zeigt einen bevorzugte Anordnung und Verschaltung von jeweiligen LED-Strängen 6a"", 6b"", die in den flächigen Sektoren 3a"", 3b"", 3c"", 3d"" des in Figur 6 gezeigten Lichtfelds 2"" vorzugsweise eingesetzt werden. Die LED-Stränge 6a"", 6b"" sind vorzugsweise mit blauen LEDs bestückt.

Wie oben erläutert, kann auf die jeweiligen LED-Strängen 6a"", 6b"" eine entsprechende Vergussmasse (beispielsweise eine Vergussmasse auf Silikonbasis) aufgetragen werden, die transparent oder mit einer Leuchtstoffbeladung ausgebildet ist. Beispielsweise können die flächigen Sektoren zur Erzeugung des ersten Lichtspektrums (d.h. die Kreissektoren 3d"" und Kreisringsektoren 3a"") mit einer Vergussmasse bedeckt werden, die eine Leuchtstoffbeladung aufweist. Wohingegen die flächigen Sektoren zur Bereitstellung des zweiten Lichtspektrums (d.h. die Kreissektoren 3c"" und Kreisringsektoren 3b"") mit einer transparenten Vergussmasse bedeckt werden.

Wie in Figur 7 ebenfalls zu erkennen, sind in den flächigen Sektoren 3a"", 3b"", 3c"", 3d"" vorzugsweise LED-Stränge 6a"", 6b"" mit identischer Anzahl an LEDs (hier beispielsweise LED-Stränge mit 12 blauen LEDs) angeordnet.

In der gezeigten bevorzugten Ausführungsform sind die Kreissektoren 3d"" und Kreisringsektoren 3a"" zur Erzeugung des ersten Lichtspektrums miteinander verschaltet (wobei in Figur 7 die jeweiligen Spannungspotentiale für die LED-stränge 6a"" durch *"CW*+*"* und *"CW-"* und die jeweiligen Spannungspotentiale für die LED-Stränge 6b"" durch *"WW*+*"* und *"WW-"* gekennzeichnet sind) und gemeinsam ansteuerbar. Wie zu erkennen, werden die spannungsführenden Leitungen vorzugsweise im Übergangsbereich zwischen jeweiligen flächigen Sektoren geführt. Alternativ ist es auch möglich, spannungsführende Leitungen zu jedem einzelnen flächigen Sektor zu führen, so dass die flächigen Sektoren jeweils einzeln ansteuerbar sind.

Die vorliegende Erfindung ist nicht auf die vorhergehenden Ausführungsbeispiele beschränkt, solange sie vom Gegenstand der folgenden Ansprüche umfasst ist. Ferner sind die vorhergehenden Ausführungsbeispiele in beliebiger Weise mit- und untereinander kombinierbar. Insbesondere sind alle oben beschriebenen Lichtfelder in einem oben beschriebenen LED-Modul verwendbar, so dass die jeweiligen Erläuterungen Hinsichtlich des mit dem LED-Moduls bzw. der jeweiligen Lichtfeldern grundsätzlich für alle Lichtfelder gelten, soweit nicht explizit Unterschiede hervorgehoben wurden.

## Patentansprüche

1. LED-Modul (1) zur Abgabe von Mischlicht, vorzugsweise von Weißlicht, umfassend:
ein Lichtfeld (2"'; 2"'), das in mehrere flächige Sektoren zum Abgeben von unterschiedlichen Lichtspektren unterteilt ist, wobei die flächigen Sektoren des Lichtfeldes (2"'; 2"") als Kreissektoren (3c"', 3d"'; 3"", 3d"") und Kreisringsektoren (3a"", 3b"'; 53a"", 3b"") ausgebildet sind,
**dadurch gekennzeichnet, dass**
das Lichtfeld (2"'; 2"") mit den flächigen Sektoren (3a"', 3a"", 3b"', 3b"", 3c"', 3"", 3d"', 3d"") durch Dispensverfahren hergestellt ist.

2. LED-Modul (1) nach Anspruch 1, wobei für jedes Lichtspektrum wenigstens zwei flächige Sektoren (3a"', 3a"", 3b"', 3b"", 3c"', 3c"", 3d"', 3d"") vorgesehen sind.

3. LED-Modul (1) nach einem der Ansprüche 1 oder 2, wobei die Außenkontur des Lichtfeldes (2"'; 2"") kreisförmig ist.

4. LED-Modul (1) nach einem der Ansprüche 1 bis 3, wobei das Lichtfeld (2"'; 2"") einen Durchmesser von 16 mm oder weniger aufweist.

5. LED-Modul (1) nach einem der Ansprüche 1 bis 4, das ferner eine Lichtstreuscheibe (4) aufweist, die in einem Abstand zum Lichtfeld (2"'; 2"") in Lichtabstrahlrichtung des Lichtfeldes (2"'; 2"") angeordnet ist, wobei vorzugsweise die Streuscheibe (4) durch eine Mischkammer von der Oberseite des Lichtfeldes (2"'; 2"") getrennt ist.

6. LED-Modul (1) nach einem der Ansprüche 1 bis 5, wobei die flächigen Sektoren (3a"', 3a"", 3b"', 3b"", 3c"', 3"", 3d"', 3d"") des Lichtfeldes (2"'; 2"") durch Dämme (5) voneinander getrennt sind, und
wobei vorzugsweise die Dämme (5) eine in Draufsicht gesehene Breite zwischen 50 µm und 2 mm aufweisen, besonders bevorzugt zwischen 100 µm und 1 mm und weiter bevorzugt zwischen 300 µm und 800 µm.

7. LED-Modul (1) nach einem der Ansprüche 1 bis 6, wobei die Dämme (5) reflektierend ausgebildet sind, vorzugsweise mit einer spiegelnden, weißen oder metallisierten Oberfläche.

8. LED-Modul (1) nach einem der Ansprüche 1 bis 7, wobei die flächigen Sektoren (3a"', 3a"", 3b"', 3b"", 3c"', 3"", 3d"', 3d"") des Lichtfeldes (2"'; 2"") eine transparente Vergussmasse oder eine einen Leuchtstoff enthaltende Vergussmasse umfassen, wobei der Leuchtstoff vorzugsweise anorganisches Leuchtstoff oder Q-dot ist, und wobei die Vergussmasse vorzugsweise eine Vergussmasse auf Silikonbasis ist.

9. LED-Modul gemäß einem der Ansprüche 1 bis 8, wobei die flächigen Sektoren (3a"', 3a"", 3b"', 3b"", 3c"', 3c"", 3d"', 3d"") zumindest zum Abgeben von Licht aus dem blauen Lichtspektrum beziehungsweise Licht aus einem weiteren durch einen Leuchtstoff erzeugten Lichtspektrum ausgelegt sind.

10. LED-Modul gemäß einem der Ansprüche 1 bis 9, wobei die flächigen Sektoren (3a"', 3a"", 3b"', 3b"", 3c"', 3"", 3d"', 3d"") jeweils mit wenigstens einer LED oder einem LED-Strang (6a"", 6b"") versehen sind.

11. LED-Modul (1) nach einem der Ansprüche 1 bis 10, wobei Licht mit mindestens 2 unterschiedlichen Lichtspektren von den flächigen Sektoren (3a"', 3a"", 3b"', 3b"", 3c"', 3"", 3d"', 3d"") emittiert ist, und wobei vorzugsweise eine von den Lichtspektren ein Peak im Bereich von 520-580nm aufzeigt.

12. LED-Modul (1) nach Anspruch 11, wobei eine von den Lichtspektren mindestens 2 Peaks aufzeigt, und
wobei vorzugsweise ein Peak im Bereich von 520-580nm und ein anderer im Bereich von 580-650nm positioniert sind.

13. LED-Modul (1) nach einem der Ansprüche 1 bis 11, wobei Weißlicht mit mindestens 2 unterschiedlichen Farbtemperaturen von den flächigen Sektoren emittiert ist, und
wobei vorzugsweise eine erste Farbtemperatur im Bereich von 2700-6500K und eine zweite Farbtemperatur im Bereich von 6500-10000K liegen.

14. LED-Modul (1) zur Abgabe von Mischlicht, vorzugsweise von Weißlicht, umfassend:
ein Lichtfeld (2"'; 2""), das in mehrere flächige Sektoren zum Abgeben von unterschiedlichen Lichtspektren unterteilt ist,
wobei die flächigen Sektoren des Lichtfeldes (2"') Kreisringsektoren (3a"', 3b"'; 3a"", 3b"") aufweisen,
**dadurch gekennzeichnet, dass**
Weißlicht mit mindestens 2 unterschiedlichen Farbtemperaturen von den flächigen Sektoren emittiert wird,,
wobei das Lichtfeld (2"'; 2"") mit den flächigen Sektoren (3a"', 3a"", 3b"', 3b"", 3c"', 3c"", 3d"', 3d"") durch Dispensverfahren hergestellt ist.

15. LED-Modul nach Anspruch 14,
wobei die flächigen Sektoren (3a"', 3a"", 3b"', 3b"", 3c"', 3c"", 3d"', 3d"") des Lichtfeldes (2"'; 2"") durch Dämme (5) voneinander getrennt sind.

16. LED-Modul nach einem der Ansprüche 13 oder 14,
wobei die unterschiedlichen Lichtspektren ein warmes Weiss und ein kaltes Weiss aufweisen.

17. LED-Modul nach einem der Ansprüche 14 bis 16,
wobei die flächigen Sektoren (3a"', 3a"", 3b"', 3b"", 3c"', 3"", 3d"', 3d"") zumindest zum Abgeben von Licht aus dem blauen Lichtspektrum wenigstens eines LED-Chips des Sektors und Licht aus einem weiteren durch einen Leuchtstoff erzeugten Lichtspektrum ausgelegt sind.

18. LED-Modul (1) hergestellt nach einem Verfahren zur Herstellung eines LED-Moduls (1) zur Abgabe von Mischlicht, vorzugsweise Weißlicht, das die folgenden Schritte umfasst:
- Erzeugen eines Lichtfeldes (2"'; 2""), das in flächige Sektoren (3a"', 3a"", 3b", 3b"",3c"', 3"", 3d"', 3d"") unterteilt ist, wobei die flächigen Sektoren des Lichtfeldes (2'"; 2"") als Kreissektoren (3c"', 3d"'; 3"", 3d"") und Kreisringsektoren (3a"', 3b"'; 3a"", 3b"") ausgebildet sind, durch
- Ausbilden von Dämmen (5), welche Sektoren (3a"', 3a"", 3b"', 3b"", 3c"', 3c"", 3d"', 3d"") des Lichtfeldes (2"'; 2"") voneinander trennen; und
- Einfüllen einer transparenten Vergussmasse oder einer einen Leuchtstoff enthaltenden Vergussmasse zwischen die Dämme (5) eines jeden Sektors (3a"', 3a"", 3b"', 3b"", 3c"', 3c"", 3d"', 3d""), wobei das Einfüllen der Vergussmasse durch Dispensverfahren durchgeführt ist.

19. Leuchtvorrichtung, die wenigstens ein LED-Modul (1) gemäß einem der Ansprüche 1 bis 13 und vorzugsweise einen auf das LED-Modul (1) gesetzten Reflektor aufweist.

## Claims

1. An LED module (1) for emitting mixed light, preferably white light, comprising:
A light field (2"', 2""), which is divided into several flat sectors for dispensing different light spectra, wherein the flat sectors of the light field (2"'; 2"") are designed as sectors of a circle (3c"', 3d"'; 3"", 3d"") and sectors of a circular ring (3a"', 3b"'; 3a"", 3b""),
**characterized in that**
the light field (2"'; 2"") with the flat sectors (3a"', 3a"", 3b"', 3b"", 3c"', 3"", 3d"', 3d"") is produced by a dispensing method.

2. An LED module (1) according to Claim 1, wherein at least two flat sectors (3a"', 3a"", 3b"', 3b"", 3c"', 3"", 3d"', 3d"") are provided for each light spectrum.

3. An LED module (1) according to any one of Claims 1 or 2, wherein the outer contour of the light field (2"'; 2"") is circular.

4. An LED module (1) according to any one of Claims 1 to 3, wherein the light field (2"'; 2"") has a diameter of 16 mm or less.

5. An LED module (1) according to any one of Claims 1 to 4, which also has a light diffusing disc (4), which is arranged at a distance from the light field (2"'; 2"") in the light emission direction of the light field (2"'; 2""), wherein preferably the diffusing disc (4) is separated by a mixing chamber from the upper side of the light field (2"'; 2"").

6. An LED module (1) according to any one of Claims 1 to 5, wherein the flat sectors (3a"', 3a"", 3b"', 3b"", 3c"', 3"", 3d"', 3d"") of the light field (2"'; 2"") are separated from one another by dams (5), and wherein preferably the dams (5) have a width seen in a top view between 50 µm and 2 mm, particularly preferably between 100 µm and 1 mm and more preferably between 300 µm and 800 µm.

7. An LED module (1) according to any one of Claims 1 to 6, wherein the dams (5) are designed to be reflective, preferably with a mirroring, white or metallized surface.

8. An LED module (1) according to any one of Claims 1 to 7, wherein the flat sectors (3a"', 3a"", 3b"', 3b"", 3c"', 3"", 3d"', 3d"") of the light field (2"'; 2"") comprise a transparent casting compound or a casting compound containing a luminescent substance, wherein the luminescent substance is preferably an inorganic luminescent substance or Q-dot, and wherein the casting compound is preferably a silicone-based casting compound.

9. An LED module according to any one of Claims 1 to 8, wherein the flat sectors (3a"', 3a"", 3b"', 3b"", 3c"', 3"", 3d"', 3d"") are designed at least for dispensing light from the blue light spectrum or light from a further light spectrum generated by a luminescent substance.

10. An LED module according to any one of Claims 1 to 9, wherein the flat sectors (3a"', 3a"", 3b"', 3b"", 3c"', 3c"", 3d"', 3d"") are provided in each case with at least one LED or an LED strand (6a"", 6b"").

11. An LED module (1) according to any one of Claims 1 to 10, wherein light is emitted with at least 2 different light spectra from the flat sectors (3a"', 3a"", 3b"', 3b"", 3c"', 3"", 3d"', 3d""), and wherein preferably one of the light spectra exhibits a peak in the range of 520-580 nm.

12. An LED module (1) according to Claim 11, wherein one of the light spectra exhibits at least 2 peaks, and
wherein preferably one peak is positioned in the range of 520-580 nm and another one in the range of 580-650 nm.

13. An LED module (1) according to any one of Claims 1 to 11, wherein white light is emitted with at least 2 different color temperatures from the flat sectors, and
wherein preferably a first color temperature lies in the range of 2700-6500 K and a second color temperature lies in the range of 6500-10000 K.

14. An LED module (1) for emitting mixed light, preferably white light, comprising:
A light field (2'", 2""), which is divided into several flat sectors for dispensing different light spectra, wherein the flat sectors of the light field (2"') have sectors of a circular ring (3a"', 3b"'; 3a"", 3b""),
**characterized in that**
white light is emitted with at least 2 different color temperatures from the flat sectors,
wherein the light field (2"'; 2"") with the flat sectors (3a"', 3a"", 3b"', 3b"", 3c"', 3"", 3d"', 3d"") is produced by a dispensing method.

15. An LED module according to Claim 14,
wherein the flat sectors (3a"', 3a"", 3b"', 3b"", 3c"', 3"", 3d"', 3d"") of the light field (2"'; 2"") are separated from one another by dams (5).

16. An LED module according to any one of Claims 13 or 14,
wherein the different light spectra have a warm white and a cold white.

17. An LED module according to any one of Claims 14 to 16,
wherein the flat sectors (3a"', 3a"", 3b"', 3b"", 3c"', 3"", 3d"', 3d"") are designed at least for dispensing light from the blue light spectrum at least of an LED chip of the sector and light from a further light spectrum generated by a luminescent substance.

18. An LED module (1) produced according to a method for the production of an LED module (1) for emitting mixed light, preferably white light, which comprises the following steps:
- generating a light field (2"'; 2""), which is divided into flat sectors (3a"', 3a"", 3b"', 3b"", 3c"', 3"", 3d"', 3d""), wherein the flat sectors of the light field (2"'; 2"") are designed as sectors of a circle (3c"', 3d"'; 3"", 3d"") and sectors of a circular ring (3a"', 3b"'; 3a"", 3b""), by
- forming dams (5), which separate sectors (3a'", 3a"", 3b"', 3b"", 3c"', 3"", 3d"', 3d"") of the light field (2"'; 2"") from one another; and
- filling in a transparent casting compound or a casting compound containing a luminescent substance between the dams (5) of each sector (3a"', 3a"", 3b"', 3b"", 3c"', 3"", 3d"', 3d""), wherein the filling in of the casting compound is carried out by a dispensing method.

19. A lighting device which has at least one LED module (1) according to any one of Claims 1 to 13 and preferably has a reflector positioned on the LED module (1).

## Revendications

1. Module à LED (1) pour l'émission d'une lumière mélangée, de préférence de lumière blanche, comprenant :
un champ lumineux (2"' ; 2"") qui est divisé en plusieurs secteurs de surfaces pour l'émission de différents spectres lumineux, les secteurs de surfaces du champ lumineux (2"' ; 2"") étant conçus comme des secteurs circulaires (3c"', 3d"' ; 3"", 3d"") et des secteurs annulaires (3a"', 3b"' ; 3a"", 3b""),
**caractérisé en ce que**
le champ lumineux (2"' ; 2"") est réalisé avec les secteurs de surfaces (3a"', 3a"", 3b"', 3b"", 3c"', 3"", 3d"', 3d"") par un procédé de dispersion.

2. Module à LED (1) selon la revendication 1, moyennant quoi, pour chaque spectre lumineux, sont prévus au moins deux secteurs de surfaces (3a"', 3a"", 3b"', 3b"", 3c"', 3"", 3d"', 3d"").

3. Module à LED (1) selon la revendication 1 ou 2, le contour externe du champ lumineux (2"' ; 2"") étant de forme circulaire.

4. Module à LED (1) selon l'une des revendications 1 à 3, le champ lumineux (2"' ; 2"") présentant un diamètre de 16 mm ou moins.

5. Module à LED (1) selon l'une des revendications 1 à 4, qui comprend au moins un disque de diffusion de lumière (4) qui est disposé à une distance du champ lumineux (2"' ; 2"") dans la direction d'émission de lumière du champ lumineux (2"' ; 2""), de préférence le disque de diffusion (4) étant séparé du côté supérieur du champ lumineux (2"' ; 2"") par une chambre de mélange.

6. Module à LED (1) selon l'une des revendications 1 à 5, les secteurs de surfaces (3a"', 3a"", 3b"', 3b"", 3c"', 3"", 3d"', 3d"") du champ lumineux (2"' ; 2"") étant séparés les uns des autres par des barrières (5) et de préférence les barrières (5) présentant une largeur, en vue de dessus, entre 50 µm et 2 mm, de préférence entre 100 µm et 1 mm et de préférence entre 300 µm et 800 µm.

7. Module à LED (1) selon l'une des revendications 1 à 6, les barrières (5) étant conçus de manière réfléchissante, de préférence avec une surface de type miroir, blanche ou métallisée.

8. Module à LED (1) selon l'une des revendications 1 à 7, les secteurs de surfaces (3a"', 3a"", 3b"', 3b"", 3c"', 3"", 3d"', 3d"") du champ lumineux (2"' ; 2"") comprenant une masse de scellement transparente ou une masse de scellement contenant une matière luminescente, la matière luminescente étant de préférence une matière luminescente inorganique ou Q-dot et la masse de scellement étant une masse de scellement à base de silicone.

9. Module à LED (1) selon l'une des revendications 1 à 8, les secteurs de surfaces (3a"', 3a"", 3b"', 3b"", 3c"', 3"", 3d"', 3d"") étant conçus au moins pour l'émission d'une lumière provenant du spectre de lumière bleue ou d'une lumière provenant d'un autre spectre de lumière généré par une matière luminescente.

10. Module à LED (1) selon l'une des revendications 1 à 9, les secteurs de surfaces (3a"', 3a"", 3b"', 3b"", 3c"', 3"", 3d"', 3d"") étant munis chacun d'une LED ou d'une chaîne de LED (6a"", 6b"").

11. Module à LED (1) selon l'une des revendications 1 à 10, la lumière étant émise avec au moins deux spectres lumineux différentes par les secteurs de surfaces (3a"', 3a"", 3b"', 3b"", 3c"', 3"", 3d"', 3d"") et de préférence un des spectres lumineux présentant un pic de l'ordre de 520 à 580 nm.

12. Module à LED (1) selon la revendication 11, un des spectres lumineux présentant au moins deux pics et
de préférence un pic étant positionné dans la plage de 520 à 580 nm et un autre pic étant positionné dans la plage de 580 à 650 nm.

13. Module à LED (1) selon l'une des revendications 1 à 11, une lumière blanche avec au moins deux températures de couleurs différentes étant émise par les secteurs de surfaces et
de préférence une première température de couleur se trouvant dans la plage de 2700 à 6 500 K et une deuxième température de couleur se trouvant dans la plage de 6500 à 10 000 K.

14. Module à LED (1) pour l'émission de lumière mélangée, de préférence de lumière blanche, comprenant :
un champ lumineux (2"' ; 2"") qui est divisé en plusieurs secteurs de surfaces pour l'émission de différents spectres lumineux,
les secteurs de surfaces du champ lumineux (2"') comprenant des secteurs annulaires (3a"', 3b"' ; 3a"", 3b""),
**caractérisé en ce que**
une lumière blanche avec au moins deux températures de couleurs différentes est émise par les secteurs de surfaces,
le champ lumineux (2"' ; 2"") étant réalisé avec les secteurs de surfaces (3a"', 3a"", 3b"', 3b"", 3c"', 3"", 3d"', 3d"") par un procédé de dispersion.

15. Module à LED selon la revendication 14,
les secteurs de surfaces (3a"', 3a"", 3b"', 3b"", 3c"', 3"", 3d"', 3d"") du champ lumineux (2"' ; 2"") étant séparés les uns des autres par des barrières (5).

16. Module à LED selon l'une des revendications 13 ou 14,
les différents spectres lumineux présentant un blanc chaud et un blanc froid.

17. Module à LED selon l'une des revendications 14 à 16,
les secteurs de surfaces (3a"', 3a"", 3b"', 3b"", 3c"', 3"", 3d"', 3d"") étant conçus au moins pour l'émission d'une lumière provenant du spectre de lumière bleue d'au moins une puce à LED du secteur et d'une lumière provenant d'un spectre lumineux généré par une matière luminescente.

18. Module à LED (1) fabriqué selon un procédé pour la fabrication d'un module à LED (1) pour l'émission de lumière mélangée, de préférence d'une lumière blanche, qui comprend les étapes suivantes :
- réalisation d'un champ lumineux (2"' ; 2"") qui est divisé en secteurs de surfaces (3a"', 3a"", 3b"', 3b"", 3c"', 3"", 3d"', 3d""), les secteurs de surfaces du champ lumineux (2"' ; 2"") étant conçus comme des secteurs circulaires (3c"', 3d"' ; 3"", 3d"") et comme des secteurs annulaires (3a"', 3b"' ; 3a"", 3b""), par
- la formation de barrières (5), qui séparent les secteurs (3a"', 3a"", 3b"', 3b"", 3c"', 3"", 3d"', 3d"") du champ lumineux (2"' ; 2"") les uns des autres ; et
- introduction d'une masse de scellement transparente ou d'une masse de scellement contenant une matière luminescente entre les barrières (5) de chaque secteur (3a"', 3a"", 3b"', 3b"", 3c"', 3"", 3d"', 3d""), l'introduction de la masse de scellement étant effectué par un procédé de dispersion.

19. Dispositif d'éclairage, qui comprend au moins un module à LED (1) selon l'une des revendications 1 à 13 et de préférence un réflecteur posé sur le module à LED (1).
